# EUROPEAN PATENT SPECIFICATION

(11) **EP 3 916 767 B1**
(45) Date of publication and mention of the grant of the patent: **06.03.2024**
(21) Application number: 20832764.3
(22) Date of filing: 16.01.2020
(51) Int. Cl.: H01L 21/78, H01L 23/00, H01L 23/58, H01L 25/00, H01L 29/06

(54) **METHOD FOR MANUFACTURING A WAFER**
VERFAHREN ZUR HERSTELLUNG EINES WAFERS
PROCÉDÉ DE FABRICATION D'UNE TRANCHE

(30) Priority: 28.06.2019 CN 201910579219
(43) Date of publication of application: 01.12.2021
(73) Proprietor: Changxin Memory Technologies, Inc., Anhui 230000 (CN)
(72) Inventor: WU, Ping-Heng, Hefei, Anhui 230000 (CN)
(74) Representative: Lavoix
(86) International application number: PCT/CN2020/072496
(87) International publication number: WO 2020/258865

(56) References cited:
- US-A1- 2011 127 631
- US-A1- 2012 228 777
- US-A1- 2015 069 609
- US-A1- 2018 277 493

## Description

This application claims the priority to CN Patent Application CN201910579219.4 filed on June 28, 2019.

### Technical field

The present disclosure relates to the field of semiconductor technology, and in particular to a wafer, a manufacturing method thereof and a semiconductor device.

### Background

With the development of integrated circuit (IC) technology, the integration level of IC chips is getting ever higher, single-wafer chips can no longer meet the requirements, therefore stacked chips built on multiple wafers have become more widely used. Stacked chips are built by dicing through multi-stacked wafers.

A multi-stacked wafer includes die areas and dicing areas. The die areas may be damaged due to the stress of the dicing operation in the dicing areas. In order to ensure that the die areas are not damaged during dicing, relatively large dicing areas are applied currently. However, the large dicing area results in a reduction in the effective utilization of the wafer and thus an increase in chip cost.

US2015/069609A1 discloses a crackstop and seal ring for 3D chip stacked wafers. A continuous through-silicon trench (TST) spans multiple wafers of a 3D chip stacked wafer and forms a closed shape around a functional circuit or die, protecting the chip during subsequent fabrication such as dicing and packaging. However, the TST with a high aspect ratio has to be formed to penetrating the stacked wafers and when the number of stacked wafers is increased, the method will be un-suitable.

It should be noted that the information disclosed in the above background section is only used to enhance the understanding of the background of the present disclosure, therefore may include information that does not constitute the information known to those of ordinary skill in the art.

### Summary

The invention is defined by the independent claim. The present disclosure provides a manufacturing method of a wafer, thereby overcoming the problems caused by the limitations and defects of related techniques.

It should be understood that the above general description and the following detailed description are only exemplary and explanatory, and cannot limit the present disclosure.

### Brief Description of the drawings

The drawings that are incorporated into the specification and constitute a part of the specification show the examples of the present disclosure, and explain the principle of the disclosure together with the specification. The drawings in the following description show only some examples of the present disclosure. For those of ordinary skill in the art, other drawings can be obtained based on these drawings without creative work.
FIG. 1 is a flowchart of a first wafer manufacturing method according to the present disclosure.
FIG. 2 is a flowchart of a second wafer manufacturing method not part of the present invention.

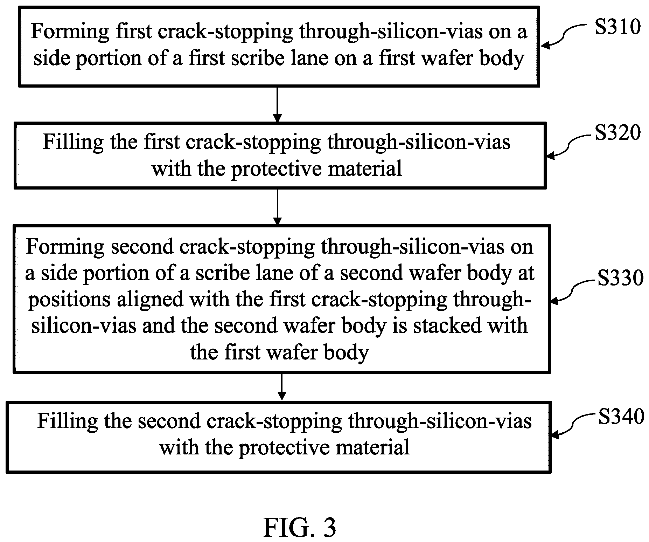

FIG. 3 is a flowchart of a third wafer fabrication method according to an exemplary embodiment of the present disclosure.
FIG. 4 is a schematic top view of a wafer according to the present disclosure.
FIG. 5 is a schematic cross-sectional view of a wafer according to an example not part of the present invention.
FIGs. 6 to 9 show process diagrams for forming the crack-stopping through-silicon-vias according to an example not part of the present invention.
FIGs. 10 and 11 show process diagrams for forming the crack-stopping through-silicon-vias according to a further exemplary embodiment of the present disclosure.
FIG. 12 is a schematic diagram of the distribution of the crack-stopping through-silicon-vias according to an exemplary embodiment of the present disclosure.
FIG. 13 is a schematic diagram of a crack-stopping through-silicon-via according to an exemplary embodiment of the present disclosure.
FIG. 14 is a schematic diagram of the distribution of the type of crack-stopping through-silicon-vias according to a further exemplary embodiment of the present disclosure.

The following list shows the reference numerals in the figures:
100, wafer body; 110, die region; 120, scribe lane; 200, crack-stopping through-silicon-via; 210, blind via; 230, first crack-stopping through-silicon-via; 240, second crack-stopping through-silicon-via; 250, air gap; 250, protective material layer; 300, first wafer body; 400, second wafer body.

### Detailed Description

Exemplary examples will now be described more fully with reference to the accompanying drawings. However, the exemplary examples can be implemented in various forms, and should not be construed as being limited to the examples set forth herein; on the contrary, these examples are provided so that the present invention will be comprehensive and complete, and fully convey the concept of the exemplary examples to those skilled in the art. The same reference numeral in the figures represents the same or similar structures, and thus their detailed descriptions will be omitted.

Although the terms of relative positions such as "upper" and "lower" are used in this specification to describe the relative relationship of one component to another, these terms are used in this specification only for convenience according to for example, the exemplary directions shown in the drawings. It can be understood that if a device of a figure is turned upside down, the component described as "upper" will become the "lower" component. When a certain structure is "on" another structure, it may mean that the certain structure is integrally formed on said structure, or that the certain structure is "directly" arranged on said structure, or that the certain structure is "indirectly" arranged on said structure with an inserted structure therebetween.

The terms "one", "a", "the", "said" and "at least one" are used to indicate the presence of one or more elements/components/etc. The terms "include/including" and "have/having" are used to indicate open-ended inclusive, and mean that in addition to the listed elements/components/etc., there may be other elements/components/etc.. The terms "first", "second" and "third" are only used as a label, not a limit to the number of objects.

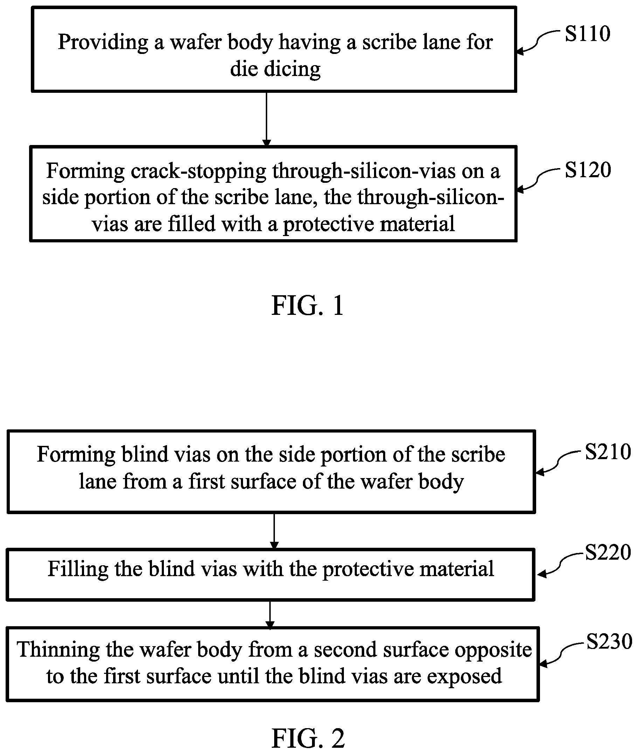

Firstly, the disclosure provides a wafer manufacturing method. As shown in FIG. 1, the wafer manufacturing method may include the following steps:
step S110, providing a wafer body 100 with a scribe lane 120 for dicing; and
step S120, crack-stopping through-silicon-vias 200 are formed on a side portion of the scribe lane 120, and the through-silicon-vias are filled with a protective material.

In the wafer manufacturing method provided in the disclosure, by providing crack-stopping through-silicon-vias 200 that are filled with the protective material on both sides of the scribe lane 120, the damage of the die region 110 caused by the dicing stress is prevented during wafer dicing. The crack-stopping through-silicon-vias 200 can effectively reduce the width of the scribe lane 120 and facilitate miniaturization of the scribe lane 120, thereby improving the effective wafer utilization.

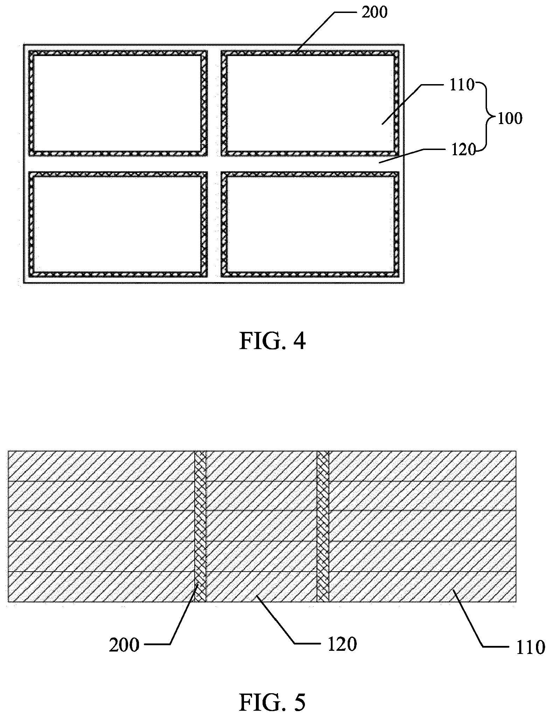

In step S 110, as shown in FIG. 5, the wafer body 100 may be divided into the scribe lanes 120 and the die regions 110, and during dicing, a dicing knife acts on the scribe lanes 120 while the die regions 110 are untouched. The wafer body 100 includes a silicon based substrate such as a silicon epitaxial wafer, or silicon-on-insulator. A dielectric layer may be provided on the substrate, and the material of the dielectric layer may be one or more of silicon oxide, silicon nitride, or silicon oxynitride. The dielectric layer may be formed by a method such as chemical vapor deposition, atomic layer deposition, or the like, in specific implementations. It is understood that the dielectric layer may be one layer of insulating material, or may be stacked layers of the same or different insulating materials.

In a feasible implementation manner provided by an example not part of the present invention. step S120 may comprise the following steps as shown in FIG. 2:
step S210, blind vias 210 are formed on a side portion of the scribe lane 120 on a first surface of the wafer body 100;
step S220, the blind vias 210 are filled with a protective material; and
step S230, a second surface opposite to the first surface of the wafer body 100 is thinned until the blind vias 210 are exposed.

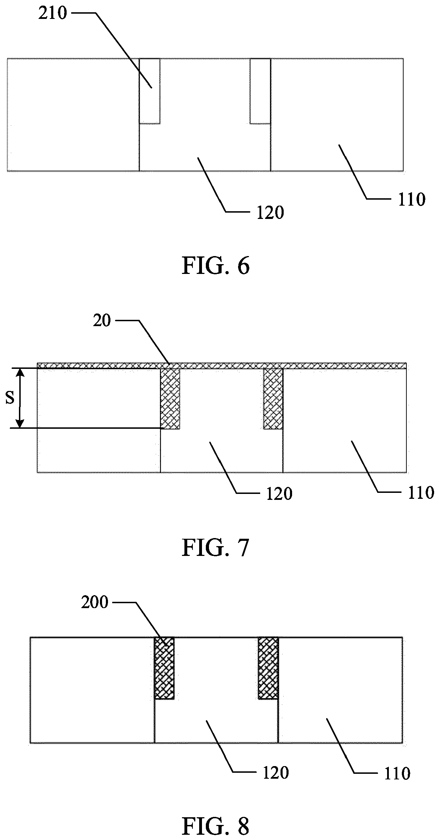

In step S210, as shown in FIG. 6, the blind vias 210 are formed on a side portion of the scribe lane 120 from the first surface of the wafer body 100. Herein the blind vias 210 may be formed by dry etching, wet etching, laser etching, or dry and wet combined etching. For example, the dry etching may be reactive ion etching or inductively coupled plasma etching, and the wet etching may use hydrofluoric acid solution, hydrofluoric acid buffered etching solution, potassium hydroxide solution, or TMAH solution. The blind vias 210 are located at a side portion of the scribe lane 120 having the cross section of a rectangular or trapezoidal shape.

It should be noted that the positions of the blind vias 210 can be defined by a photoresist, which can be coated on the first side of the wafer body 100, exposed with a corresponding photomask to transfer the pattern of the photomask to the photoresist, and developed such that the photoresist layer exposes the regions where the crack-stopping through-silicon vias 200 are to be formed; and the blind vias 210 are then formed by etching.

In step S220, as shown in FIG. 7, a protective material may be filled in the blind hole 210. The protective material may be one or more of conductive materials such as copper, tungsten, aluminum, tantalum, titanium, tantalum nitride, titanium nitride and the like. Before the protective material, an insulating layer may be deposited on the first surface of the wafer body 100 and on the inside walls of the blind hole 210. For example, the insulating layer can be formed by chemical vapor deposition, physical vapor deposition, or thermal growth. The above-mentioned conductive material then fills in the blind hole 210, by electroplating, for example. In electroplating, a seed layer is first deposited on the insulating layer, and a metal protective layer is electroplated on the seed layer. During the electroplating process, a metal layer is also formed on the first surface of the wafer body 100, as shown in FIG. 8, which needs to be removed by such as etching or chemical mechanical polishing.

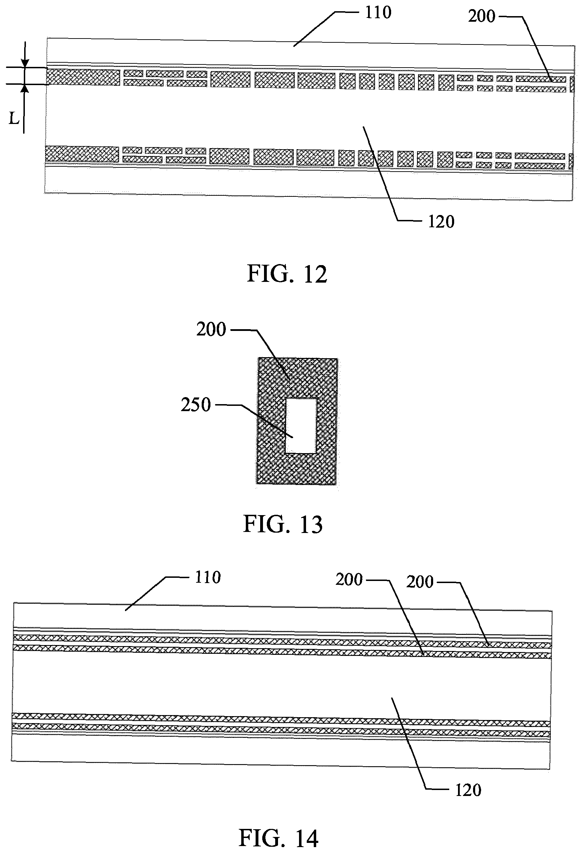

When the filling material is one or more of silicon oxide, silicon nitride, silicon oxynitride, silicon carbide, silicon carbonitride, polyimide, and tetraethyl orthosilicate, it may be filled with a process of chemical vapor deposition or physical vapor deposition or thermal growth. At the same time, as shown in FIG. 7, a protective material layer 20 is also formed on the first surface of the wafer body 100. The protective material layer 20 can be removed or not removed according to actual needs. Further, as shown in FIG. 13, an air gap 250 may be formed inside the protective material filled in the blind via 210.

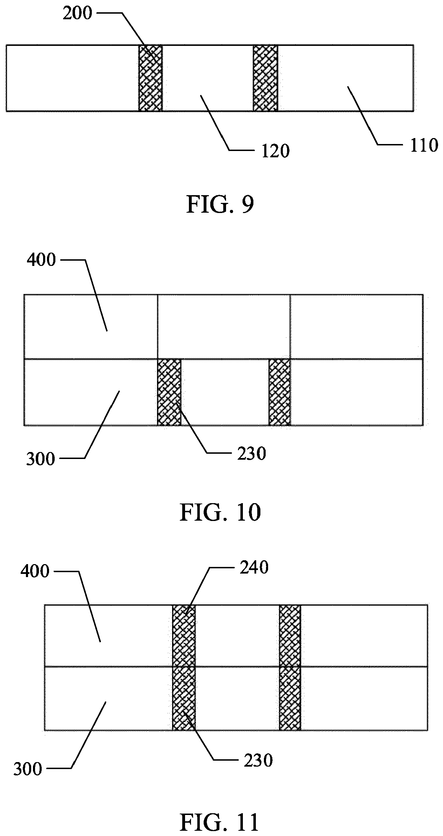

In step S230, as shown in FIG. 9, the second surface of the wafer body 100 is thinned until the blind vias 210 are exposed. The second surface of the wafer body 100 which is opposite to the first surface may be thinned by etching or chemical mechanical polishing. For example, the first surface of the wafer body 100 may be the front side of the wafer body 100, and the second side is the back side of the wafer body 100.

In the present invention, step S120 includes:
step S310, forming first crack-stopping through-silicon-vias 230 on a side portion of a scribe line 120 on a first wafer body 300;
step S320, filling the first crack-stopping through-silicon-vias 230 with a protective material;
step S330, forming second crack-stopping through-silicon-vias 240 on a side portion of a scribe lane 120 on a second wafer body 400 that is stacked with the first wafer body 300, at positions which align to the first crack-stopping through-silicon-vias 230; and
step S340, filling the protective material in the second crack-stopping through-silicon-vias 240.

In step S310, as shown in FIG. 10, the first crack-stopping through-silicon-vias 230 is formed on the side portion of the scribe line 120 on the first wafer body 300. In the case of multiple layers of stacked wafers, the process is rather complicated in which blind vias 210 may be firstly formed on each of the wafer bodies, then the wafer bodies 100 are thinned after filling the vias with the protective material and lastly bonded together to form the multiple layers of stacked wafers. Therefore, a process is adopted, in which a two-wafer stack structure is formed first, and then crack-stopping through-silicon-vias are formed on each of the wafer bodies 100. This process can simplify the manufacturing process and improve the production efficiency. For example, the two-wafer stack structure includes the first wafer body 300 and the second wafer body 400 that are stacked together. The first crack-stopping through-silicon-vias 230 is formed on the first wafer body 300 to expose the second wafer 400. The first crack-stopping through-silicon-vias 230 are filled with a protective material. Then second crack-stopping through-silicon-vias 240, which respectively align exactly to the first crack-stopping through-silicon-vias 230 is formed on the surface of the second wafer body 400 to expose the first crack-stopping through-silicon-vias 230. Then the second crack-stopping through-silicon-vias 240 are filled with the protective material. This process omits the thinning step, therefore it simplifies the manufacturing process.

The first crack-stopping through-silicon-vias 230 may be formed by dry etching, wet etching, laser etching, or combined dry and wet etching. For example, the dry etching may be the reactive ion etching or the inductively coupled plasma etching, and the wet etching may be etching with hydrofluoric acid solution, hydrofluoric acid buffered etching solution, potassium hydroxide solution, or TMAH solution. The first crack-stopping through-silicon-vias 230 are located at the side of the scribe line 120 having the cross section of rectangular or trapezoidal shape.

It should be noted that the positions of the first crack-stopping through-silicon-vias 230 may be defined by a photoresist which is coated on the surface of the first wafer body 300, exposed with a corresponding mask to transfers the pattern of the mask to the photoresist layer; and developed to expose the regions where the first crack-stopping through-silicon-vias 230 are to be formed and the first crack-stopping through-silicon-vias 230 are then formed by etching.

In step S320, a protective material is filled in the first crack-stopping through-silicon-via 230. The protective material is one or more of the conductive materials such as copper, tungsten, aluminum, tantalum, titanium, tantalum nitride and titanium nitride. At this time, before the protective material, a layer of insulating material may be formed on the walls of the first crack-stopping through-silicon-vias 230 and on the surface of the wafer body 100 as well. The insulating layer may be formed, for example, by chemical vapor deposition, physical vapor deposition or thermal growth. The above-mentioned conductive material may be filled in the first crack-stopping through-silicon-vias 230, for example, by electroplating. First, a seed layer is deposited on the surface of the insulating layer, and then a metal protective layer is electroplated on the seed layer. During the electroplating process, the metal layer is also formed on the surface of the wafer body 100, and the metal layer needs to be removed, for example, by etching or chemical mechanical polishing.

When the filling material is one or more of silicon oxide, silicon nitride, silicon oxynitride, silicon carbide, silicon carbonitride, polyimide, and tetraethyl orthosilicate, it may be filled in by such as chemical vapor deposition, physical vapor deposition or thermal growth. At the same time, a protective material layer 20 is also formed on the surface of the first wafer body 300. At this time, the protective material layer 20 may be removed or may not be removed according to actual needs. Further, an air gap 250 may be formed within the protective material filled in the first crack-stopping through-silicon-via 230.

In step S330, as shown in FIG. 11, the second crack-stopping through-silicon-vias 240 respectively aligning to the first crack-stopping through-silicon-vias 230 is formed on the side portion of the scribe lane 120 on the second wafer body 400. Herein, the second crack-stopping through-silicon-vias 240 is formed by dry etching, wet etching, laser etching, or dry and wet combined etching. For example, the dry etching may be the reactive ion etching or the inductively coupled plasma etching, and the wet etching may be etching with a potassium hydroxide solution. The second crack-stopping through-silicon-vias 240 are located on the side of the scribe line 120 and the cross-section of the second crack-stopping through-silicon-vias 240 may be rectangular or trapezoidal.

It should be noted that the position of the second crack-stopping through-silicon-vias 240 can be defined by a photoresist which is coated on the surface of the second wafer body 400, exposed with a corresponding photomask to transfer the pattern of the mask to the photoresist layer; and developed to expose the regions where the second crack-stopping through-silicon-vias 240 are to be formed; and the second crack-stopping through-silicon-vias 240 is then formed by etching.

In step S340, the second crack-stopping through-silicon-vias 240 are filled with the protective material. The protective material is one or more of the conductive materials such as copper, tungsten, aluminum, tantalum, titanium, tantalum nitride and titanium nitride. At this time, before the protective material is filled in, a layer of insulating material may be formed on the walls of the second crack-stopping through-silicon-vias 240 and on the surface of the wafer body 100 as well. The insulating layer may be formed, for example, by chemical vapor deposition, physical vapor deposition or thermal growth. The above-mentioned conductive material may be filled in the second crack-stopping through-silicon-vias 240, for example, by electroplating. First, a seed layer is deposited on the surface of the insulating layer, and then a metal protective layer is electroplated on the seed layer. During the electroplating process, the metal layer is also formed on the surface of the wafer body 100, which needs to be removed, for example, by etching or chemical mechanical polishing.

When the filling material is one or more of silicon oxide, silicon nitride, silicon oxynitride, silicon carbide, silicon carbonitride, polyimide and tetraethyl orthosilicate, it may be filled in by such as chemical vapor deposition or physical vapor deposition or thermal growth are applied. At the same time, a protective material layer 20 is also formed on the surface of the first wafer body 400. At this time, the protective material layer 20 may be removed or may not be removed according to actual needs. Further as shown in FIG. 13, an air gaps 250 may be formed within the protective material filled in the second crack-stopping through-silicon-via 240.

In the case of more layers of stacked wafers, based on the double-wafer stack structure provided with the first crack-stopping through-silicon-vias 230 and the second crack-stopping through-silicon-vias 240, each additional stacked layer of wafer may be stacked first and then subject to forming the crack-stopping through-silicon-vias. Such process can simplify the manufacturing process and improve the production efficiency.

As shown in FIG. 12, the crack-stopping through-silicon-vias 200 are formed on both sides of the scribe lane 120 along the extension direction of the scribe lane 120. The crack-stopping through-silicon-vias 200 include continuously distributed through-silicon-vias or separated distributed through-silicon-vias. Multiple rows of crack-stopping through-silicon-vias 200 may be formed on one side of the scribe lane 120. The width L of the crack-stopping through-silicon-vias 200 ranges from 2 µm to 20 µm, and the depth S of the crack-stopping through-silicon-vias 200 ranges from 15 µm to 150 µm. When there are multiple rows of crack-stopping through-silicon-vias 200 on one side of the scribe lane 120, the width L of the entire area of the through-silicon-vias ranges from 2 µm to 20 µm. The width of the crack-stopping through-silicon-vias 200 refers to the distance between the two sidewalls of the crack-stopping through-silicon-vias 200 parallel to the scribe line 120.

As shown in FIG. 14 herein, multiple rows of crack-stopping through-silicon-vias 200 may be provided on one side of the scribe lane 120, and the multiple rows of crack-stopping through-silicon-vias 200 may be arranged in parallel in the scribe lane 120. Multiple rows of crack-stopping through-silicon-vias can further ease the dicing stress.

The wafer manufacturing method provided by the present disclosure effectively prevented the damage of the die regions 110 caused by the dicing stress during wafer dicing by providing the crack-stopping through-silicon-vias 200, which are filled with the protective material and arranged along both sides the scribe lane 120. Thus, the crack-stopping through-silicon-vias 200 can effectively reduce the width of the scribe lane 120, and facilitate the miniaturization of the scribe lane 120, thereby improving the resultant wafer utilization rate, and ultimately leading to cost reduction of the chip.

The disclosure also provides a wafer. As shown in FIG. 4, the wafer includes a wafer body 100 and crack-stopping through-silicon-vias 200. The wafer body 100 is provided with a scribe channel 120 for dicing. 120. The crack-stopping through-silicon-vias 200 are provided along a side portion of the scribe lane 120 and filled with a protective material.

The wafer provided by the present disclosure prevents the damage on die regions 110 caused by the dicing stress during wafer dicing by the crack-stopping through-silicon-vias 200 filled with protective material formed along both sides of the scribe lane 120. Thus, the crack-stopping through-silicon-vias 200 can effectively reduce the width of the scribe lane 120, and facilitate the miniaturization of the scribe lane 120, thereby improving the effective utilization rate of the wafer.

The wafer body 100 can be divided into a scribe lane 120 and a die region 110. During dicing, a dicing knife acts on the scribe lane 120, while the die region 110 is retained. The wafer body 100 may be a silicon substrate including a silicon epitaxial layer, silicon on an insulator layer, etc., or a substrate of other semiconductor material such as GaN, or an intrinsic semiconductor substrate, or a N-type doped or P-type doped semiconductor substrate, however the present disclosure are not limited thereto. A dielectric layer may be disposed on the substrate. The material of the dielectric layer may be one or more of silicon oxide, silicon nitride, and silicon oxynitride. In specific implementation, the dielectric layer may be formed by a method such as chemical vapor deposition, atomic layer deposition and the like. It is understandable that the dielectric layer may be a single layer of insulating material, or may be multiple stacked layers of same or different insulating materials.

The disclosed crack-stopping through-silicon-vias 200 are formed along the extension direction of both sides of the scribe lane 120. The crack-stopping through-silicon-vias 200 include continuously distributed through-silicon vias or separately distributed through-silicon vias. Multiple rows of crack-stopping through-silicon-vias 200 may be formed on one side of the scribe lane 120. The width L of the crack-stopping through-silicon-vias 200 is ranging from 2 µm to 20 µm, and the depth S of the crack-stopping through-silicon-vias 200 is ranging from 15 µm to 150 µm. When there are multiple rows of the crack-stopping through-silicon-vias 200 on one side of the scribe lane 120, the total width L of the entire area of the crack-stopping through-silicon-vias is ranging from 2 µm to 20 µm. The width of the crack-stopping through-silicon-vias 200 refers to the distance between the two sidewalls of the crack-stopping through-silicon-vias 200 parallel to the scribe line 120.

The protective material includes one or more of copper, tungsten, aluminum, tantalum, titanium, tantalum nitride, titanium nitride, silicon oxide, silicon nitride, silicon oxynitride, silicon carbide, silicon carbon nitride, polyimide, and tetraethyl orthosilicate. Further, an air gap 250 may be provided inside the crack-stopping through-silicon-via 200.

When the protective material is one or more of conductive materials such as copper, tungsten, aluminum, tantalum, titanium, tantalum nitride and titanium nitride, the crack-stopping through-silicon-vias 200 may include an insulating layer and a protective material layer. The insulating layer is between the sidewalls of through-vias on the wafer body 100 and the protective material. Before filling the protective material, an insulating layer may be formed firstly on the through-via sidewalls and the first surface of the wafer body 100. The insulating layer can be formed by such as chemical vapor deposition, physical vapor deposition or thermal growth. The above-mentioned conductive material is filled in the through-silicon-vias by such as electroplating. Firstly, a seed layer is deposited on the insulating layer, and a metal protective layer is electroplated on the seed layer.

When the filling material is one or more of silicon oxide, silicon nitride, silicon oxynitride, silicon carbide, silicon carbonitride, polyimide and tetraethyl orthosilicate, it may be filled by chemical vapor deposition or physical vapor deposition or thermal growth. At the same time, a protective material layer 20 is formed on the first surface of the wafer body 100. At this time, the protective material layer may be removed or not be removed according to actual needs. Further, an air gap 250 may be formed inside the protective material filled in the blind via 210.

The wafer disclosed by the disclosure is provided with the crack-stopping through-silicon-vias 200 which are filled in with the protective material and disposed on both sides of the scribe lane 120, such that the die region 110 is protected from being damaged by the dicing stress during wafer dicing. Thus, the crack-stopping through-silicon-vias 200 can effectively reduce the width of the scribe lane 120 and facilitate the miniaturization of the scribe lane 120, thereby improving the effective utilization rate of the wafer, and reducing the chip cost.

The disclosure also provides a semiconductor device, which comprises multiple layers of aforementioned wafers which are stacked. Each layer of the wafer is provided with crack-stopping through-silicon-vias 200 on both sides of the scribe lane 120. The positions of the scribe lanes 120 of the layers of wafers align to each other. After the multiple layers of wafers are stacked, the projections of the scribe lanes 120 of the multiple layers of wafers overlap on any one of the wafers. As the stacked wafers are cut along the scribe lane 120, a plurality of stacked dies is obtained.

Those skilled in the art will easily think of other solutions of the present disclosure after considering the specification and practicing the disclosure herein. This application is intended to cover any variations, uses, or adaptive changes of the present disclosure. These variations, uses, or adaptive changes follow the general principles of the present disclosure and include common knowledge or conventional technical means in the technical field not disclosed in the present disclosure. The description and the examples are only regarded as exemplary examples, and the true scope and spirit of the present disclosure are indicated by the appended claims.

## Claims

1. A wafer manufacturing method, comprising:
providing a first wafer body (300) and a second wafer body (400) which are stacked, on each of which a scribe lane (120) for dicing is provided, wherein the first wafer body (300) and a second wafer body (400) respectively comprise a silicon substrate;
**characterized in that**,
forming first through-silicon-vias (230) for crack-stopping on both sides along an extension direction of the scribe lane (120) of the first wafer body (300), and exposing the second wafer body (400);
filling a protective material into the first through-silicon-vias (230);
forming second through-silicon-vias (240) for crack-stopping on both sides along an extension of the scribe lane (120) of the second wafer body (400) at positions aligned with the first through-silicon-vias (230), exposing the first through-silicon-vias (230), after filling the protective material into the first through-silicon-vias (230); and
filling the protective material into the second through-silicon-vias (240),
wherein the protective material comprises one or more selected from copper, tungsten, aluminum, tantalum, titanium, tantalum nitride, titanium nitride, silicon oxide, silicon nitride, silicon oxynitride, silicon carbide, silicon carbonitride, polyimide and tetraethyl orthosilicate.

2. The wafer manufacturing method of claim 1, wherein the first and the second through-silicon-vias (230, 240) comprise continuously distributed or separately distributed through-silicon-vias, respectively.

3. The wafer manufacturing method of claim 1, wherein two or more rows of the first and the second through-silicon-vias (230, 240) are formed on one side of the respective scribe lane (120) of the first and the second wafer bodies (300, 400).

4. The wafer manufacturing method of claim 1, wherein a width of the first and the second through-silicon-vias (230, 240) is in a range from 2 microns to 20 microns, and a depth of the first and the second through-silicon-vias (230, 240) is in a range from 15 microns to 150 microns.

5. The wafer manufacturing method according to claim 1, wherein an air gap (250) is provided in one of the first and the second through-silicon-vias (230, 240).

## Patentansprüche

1. Verfahren zur Herstellung eines Wafers, umfassend:
Bereitstellen eines ersten Waferkörpers (300) und eines zweiten Waferkörpers (400), die gestapelt sind, auf denen jeweils ein Ritzgraben (120) zum Zerteilen vorgesehen ist, wobei der erste Waferkörper (300) und ein zweiter Waferkörper (400) jeweils ein Siliziumsubstrat umfassen;
**gekennzeichnet durch**
Bilden erster Silizium-Durchgangslöcher (230) zum Rissstoppen auf beiden Seiten entlang einer Erstreckungsrichtung des Ritzgrabens (120) des ersten Waferkörpers (300), und Freilegen des zweiten Waferkörpers (400);
Einfüllen eines Schutzmaterials in die ersten Silizium-Durchgangslöcher (230);
Bilden von zweiten Silizium-Durchgangslöchern (240) zum Rissstoppen auf beiden Seiten entlang einer Verlängerung des Ritzgrabens (120) des zweiten Waferkörpers (400) an Positionen, die mit den ersten Silizium-Durchgangslöchern (230) ausgerichtet sind, Freilegen der ersten Silizium-Durchgangslöcher (230), nachdem das Schutzmaterial in die ersten Silizium-Durchgangslöcher (230) gefüllt wurde; und
Einfüllen des Schutzmaterials in die zweiten Silizium-Durchgangslöcher (240),
wobei das Schutzmaterial eines oder mehrere aus Kupfer, Wolfram, Aluminium, Tantal, Titan, Tantalnitrid, Titannitrid, Siliziumoxid, Siliziumnitrid, Siliziumoxynitrid, Siliziumcarbid, Siliziumcarbonitrid, Polyimid und Tetraethylorthosilikat ausgewählte Materialien umfasst.

2. Verfahren zur Herstellung eines Wafers nach Anspruch 1, wobei die ersten und die zweiten Silizium-Durchgangslöcher (230, 240) kontinuierlich verteilte bzw. getrennt verteilte Silizium-Durchgangslöcher umfassen.

3. Verfahren zur Herstellung eines Wafers nach Anspruch 1, bei dem zwei oder mehr Reihen der ersten und der zweiten Silizium-Durchgangslöcher (230, 240) auf einer Seite des jeweiligen Ritzgrabens (120) des ersten und des zweiten Wafer-Körpers (300, 400) ausgebildet sind.

4. Verfahren zur Herstellung eines Wafers nach Anspruch 1, wobei eine Breite der ersten und der zweiten Silizium-Durchgangslöcher (230, 240) in einem Bereich von 2 Mikron bis 20 Mikron liegt und eine Tiefe der ersten und der zweiten Silizium-Durchgangslöcher (230, 240) in einem Bereich von 15 Mikron bis 150 Mikron liegt.

5. Verfahren zur Herstellung eines Wafers nach Anspruch 1, bei dem ein Luftspalt (250) in einem der ersten und zweiten Silizium-Durchgangslöcher (230, 240) vorgesehen ist.

## Revendications

1. Procédé de fabrication d'une plaquette, comprenant :
la fourniture d'un premier corps de plaquette (300) et d'un second corps de plaquette (400) qui sont empilés, sur chacun desquels une voie de traçage (120) pour le découpage est ménagée, le premier corps de plaquette (300) et le second corps de plaquette (400) comprenant respectivement un substrat de silicium ;
**caractérisé par**
la formation de premiers vias traversants de silicium (230) pour arrêter les fissures des deux côtés le long d'une direction d'extension de la voie de traçage (120) du premier corps de plaquette (300), et l'exposition du second corps de plaquette (400) ;
le remplissage d'un matériau protecteur dans les premiers vias traversants de silicium (230) ;
la formation de seconds vias traversants de silicium (240) pour arrêter les fissures des deux côtés le long d'une extension de la voie de traçage (120) du second corps de plaquette (400) au niveau de positions alignées avec les premiers vias traversants de silicium (230), et l'exposition des premiers vias traversants de silicium (230), après avoir rempli le matériau de protection dans les premiers vias traversants de silicium (230) ; et
le remplissage du matériau de protection dans les seconds vias traversants de silicium (240),
dans lequel le matériau de protection comprend un ou plusieurs éléments choisis parmi le cuivre, le tungstène, l'aluminium, le tantale, le titane, le nitrure de tantale, le nitrure de titane, l'oxyde de silicium, le nitrure de silicium, l'oxynitrure de silicium, le carbure de silicium, le carbonitrure de silicium, le polyimide et l'orthosilicate de tétraéthyle.

2. Procédé de fabrication de plaquettes selon la revendication 1, dans lequel le premier et le second vias traversants de silicium (230, 240) comprennent des vias traversants de silicium distribués de manière continue ou distribués séparément, respectivement.

3. Procédé de fabrication de plaquettes selon la revendication 1, dans lequel deux rangées ou plus du premier et du second vias traversants de silicium (230, 240) sont formées sur un côté de la piste de traçage (120) respective du premier et du second corps de plaquette (300, 400).

4. Procédé de fabrication de plaquettes selon la revendication 1, dans lequel une largeur du premier et du second vias traversants de silicium (230, 240) est comprise entre 2 microns et 20 microns, et une profondeur du premier et du second vias traversants de silicium (230, 240) est comprise entre 15 microns et 150 microns.

5. Procédé de fabrication de plaquettes de silicium selon la revendication 1, dans lequel une lame d'air (250) est prévue dans l'un du premier et du second vias traversants de silicium (230, 240).
